# DEMANDE DE BREVET EUROPEEN

(11) **EP 0 532 400 A1**
(43) Date de publication de la demande: **17.03.1993**
(21) Numéro de dépôt: 92402443.3
(22) Date de dépôt: 07.09.1992
(51) Int. Cl.: H03D 3/08, H04L 27/14

(54) **Discriminateur de fréquence tronqué**

(30) Priorité: 09.09.1991 FR 9111102
(71) Demandeur: FRANCE TELECOM, F-75015 Paris (FR)
(72) Inventeur: Hui Bon Hoa, Daniel, F-22300 Lannion (FR); Condom, Michel, F-22560 Trebeurden (FR); Tromeur, André, F-22700 Louannec (FR)
(74) Mandataire: Signore, Robert

(57) **Abrégé**

Le discriminateur de l'invention comprend un amplificateur (A), des circuits d'ajustement de phase (CAP1, CAP2) et des moyens (V1, V2) pour polariser très faiblement en direct les diodes SCHOTTKY (DS1, DS2).

Application dans les récepteurs de télécommunications optiques.

## Description

### Domaine technique

La présente invention a pour objet un discriminateur de fréquence tronqué. Elle trouve une application en télécommunications et notamment en télécommunications optiques où elle permet de réaliser des récepteurs cohérents.

### Etat de la technique antérieure

Un discriminateur de fréquence est un circuit qui convertit un signal modulé de fréquence en un signal modulé en amplitude. Un tel circuit est défini par sa caractéristique de transfert, qui traduit la variation de la tension du signal de sortie en fonction de la fréquence du signal d'entrée.

De tels circuits sont utilisés en réception hétérodyne. Le signal incident modulé en fréquence est d'abord mélangé à un signal local de fréquence différente, ce qui conduit à un signal à une fréquence intermédiaire qui est la fréquence de battement. Cette fréquence se situe généralement vers quelques Giga-hertz. Le signal à la fréquence intermédiaire fait ensuite l'objet d'une démodulation de fréquence à l'aide d'un discriminateur.

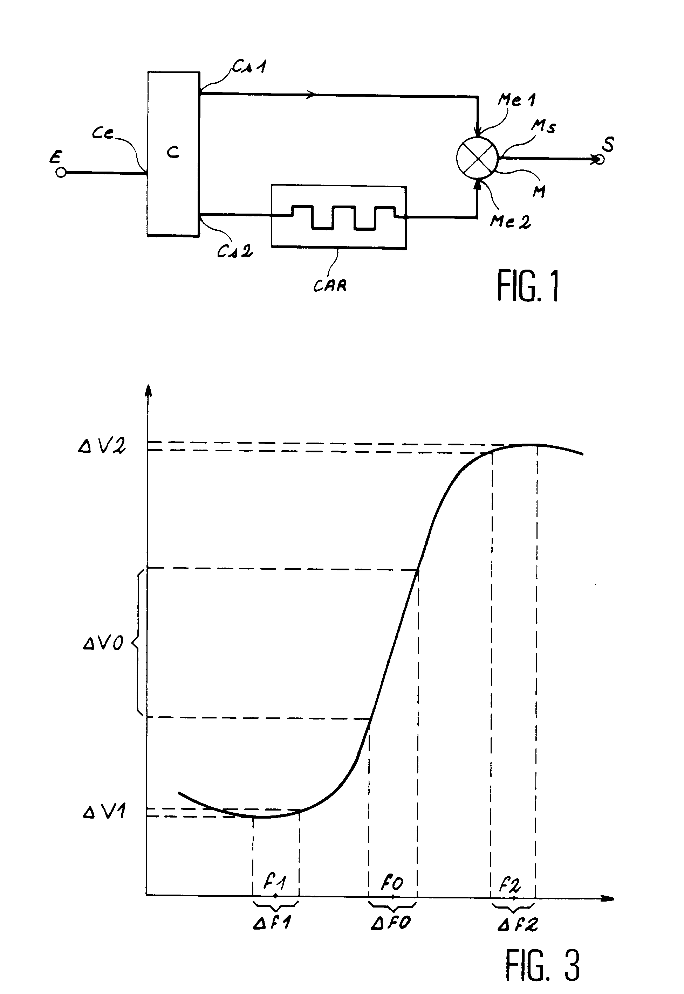

La structure générale d'un discriminateur de fréquence est représentée sur la figure 1 annexée. Elle comprend une entrée générale E, un coupleur C possédant une entrée Ce et une première et une seconde sorties Cs1, Cs2, une première voie reliée à la première sortie Cs1 et une seconde voie reliée à la seconde sortie Cs2, un circuit de retard CAR disposé dans la seconde voie, un mélangeur M possédant une première et une seconde entrée Me1, Me2, la première entrée Me1 étant reliée à la première voie et la seconde entrée Me2 étant reliée à la seconde voie et une sortie Ms. La sortie générale S du discriminateur fournit une tension dont l'amplitude reflète les variations de fréquence du signal de battement.

On peut trouver une description générale de tels circuits dans l'article de T.G. HODGKINSON et al., intitulé "Cohérent optical fibre transmission systems", publié dans la revue Br. Telecom. Technol. J., vol. 3, n° 3, pp 5-18, Juillet 1985, ou dans l'article de I. GARRETT et al., intitulé "Theory of optical heterodyne narrow-deviation FSK receivers with delay demodulation", publié dans J. Lightwave Technol., vol. LT-6, Septembre 1988, pp. 1415-1423, ou encore dans l'article de H. TSUSHIMA et al. intitulé "AMI-CPFSK Heterodyne Transmission Experiment Using a Novel Delay-Line Demodulation Method", publié dans Electronics Letters, 2 août 1990, vol. 26, n° 16, pp. 1269-1270.

En pratique, le mélangeur recevant les deux signaux retardés l'un par rapport à l'autre est constitué par deux diodes SCHOTTKY non polarisées montées en série, avec un point milieu relié à la sortie générale. Un tel circuit conduit à une caractéristique de transfert de forme quasi sinusoïdale. Les abscisses du maximum (f2) et du minimum (f1) de la courbe de réponse dépendent du temps de retard et du déphasage entre les sorties du séparateur et entre les entrées du mélangeur.

Au voisinage de la fréquence d'accord fo du discriminateur, la caractéristique de transfert est linéaire, c'est-à-dire que la variation de tension de sortie ΔVo est proportionnelle à la variation de fréquence Δfo du signal d'entrée avec une pente ΔVo/Δfo importante.

Dans le cas des systèmes de télécommunications optiques utilisant des diodes laser, les fréquences d'émission sont affectées d'un bruit de phase très important se traduisant par une largeur spectrale de la raie d'émission de quelques Mégahertz à quelques dizaines de Mégahertz. En réception hétérodyne, on obtient un signal de battement dont la largeur spectrale en l'absence de modulation est la somme des largeurs spectrales des lasers émetteur et oscillateur local. Lorsque cette fréquence de battement est calée sur la fréquence d'accord fo du discriminateur, ce dernier convertit le bruit de phase des lasers en bruit d'amplitude et l'on obtient des fluctuations très importantes de tension de bruit à la sortie du discriminateur.

En général, on module le laser émetteur par déplacement de fréquence (modulation dite FSK pour "Frequency Shift Keying") avec un code binaire par exemple, de telle sorte que la fréquence de battement reste dans la plage linéaire centrée autour de la fréquence d'accord f0 du discriminateur. Il en résulte alors une conversion du bruit de phase en bruit d'amplitude.

### Exposé de l'invention

La présente invention a justement pour but de remédier à cet inconvénient. A cette fin, elle propose de modifier les discriminateurs connus de telle sorte que la caractéristique fréquence-tension soit tronquée, c'est-à-dire présente, aux extrémités inférieure et supérieure, une plage large horizontale où une variation Δf1 de f1 (respectivement Δf2 de f2) corresponde à une variation a Δv1 (respectivement v2) de la tension de sortie très petite vis-à-vis de Δvo.

En outre la fréquence du signal de battement prend la valeur f1 correspondant à l'état 0 ou la valeur f2 correspondant à l'état 1. Elle va donc se trouver dans l'une ou l'autre des deux régions tronquées de la caractéristique de transfert et, par conséquent, la conversion du bruit de phase en bruit d'amplitude sera très faible. On recueillera, après le discriminateur tronqué, une tension de bruit beaucoup plus faible qu'avec les discriminateurs de l'art antérieur.

Durant les transitions entre les fréquences f1 et f2, le signal de battement traversera la zone linéaire et le discriminateur fournira alors une tension de bruit importante. Cependant, ces états transitoires sont brefs par rapport à la durée des états 0 et 1 et leurs contributions à la tension de bruit totale doivent être pondérées dans le temps.

Globalement, la tension de bruit résultante sera diminuée par rapport à celle que fournirait un discriminateur non tronqué et tout se passera comme si la largeur spectrale effective due à la caractéristique du discriminateur tronqué était réduite d'un facteur compris entre 3 et 5 par rapport à la largeur spectrale du signal de battement avant le discriminateur tronqué.

Le discriminateur de fréquence tronqué de l'invention permet l'emploi de diodes laser présentant des largeurs de raie beaucoup plus importantes que dans l'art antérieur. A titre d'exemple, avec un discriminateur classique, il faut une largeur de raie de battement inférieure à 0,5% du débit numérique pour obtenir un plancher de taux d'erreur de 10⁻⁹ pour une modulation FSK. Avec le discriminateur tronqué de l'invention, les inventeurs ont vérifié expérimentalement que la largeur de raie de battement pouvait être accrue jusqu'à 3,5% du débit numérique pour un taux d'erreur de 10⁻¹⁰. Cet accroissement de tolérance autorise l'usage de diodes laser ayant une spécification en bruit de phase plus relâchée et plus économique à produire.

Un autre intérêt apporté par la caractéristique tronquée est sa plus grande immunité à une réponse non uniforme en modulation de fréquence de la diode laser. Lorsque cette dernière est modulée par un courant d'amplitude constante, la déviation de la fréquence optique n'est pas constante mais varie selon la fréquence du courant de modulation. Un discriminateur de fréquence linéaire reproduit les déviations de la fréquence de battement et donne une tension de sortie dont l'amplitude est irrégulière et dépend du signal modulant. Pour réduire ces distorsions, on peut égaliser la réponse en modulation de fréquence de la diode laser. La fonction de correction dépend fortement de l'échantillon, de la température, du courant de polarisation, etc... Elle est sujette à trop d'aléas pour que la correction soit parfaite. Un second moyen pour réduire les distorsions de tension fournies par le discriminateur linéaire est d'écrêter les amplitudes. C'est justement le rôle du discriminateur tronqué de l'invention, à condition que les fréquences correspondant aux états 0 et 1 soient situées dans les plages tronquées. Les déviations de fréquence autour de f1 et de f2 sont alors converties en déviations de tensions avec des amplitudes très faibles tant qu'elles restent dans les limites des plages tronquées. Comme celles-ci sont plus larges que dans le cas d'un discriminateur de fréquence classique, le discriminateur tronqué présente une plus grande immunité vis-à-vis de la réponse non uniforme des diodes laser en modulation de fréquence.

Des mesures comparatives effectuées sur un système à 140 Mbit/s avec un discriminateur linéaire et un discriminateur tronqué ont montré que le taux d'erreur plancher a été réduit à 5.10⁻¹⁰ (soit une amélioration d'un facteur 500) avec une séquence de test pseudo-aléatoire de 127 éléments binaires.

Tous ces résultats sont atteints par l'invention en dotant le discriminateur de moyens supplémentaires permettant d'ajuster les différents signaux dans leur amplitude et leur phase, et d'ajuster également le point de fonctionnement des diodes SCHOTTKY. Selon l'invention, le coupleur est précédé d'un amplificateur de puissance, chaque voie est pourvue d'un circuit d'ajustement de la phase, les deux diodes SCHOTTKY sont associées à des circuits permettant de les polariser très légèrement en direct, et la fréquence de battement prend la valeur f1 ou f2, ces fréquences étant situées dans les plages tronquées.

### Brève description des dessins

- la figure 1, déjà décrite, montre le schéma général d'un discriminateur ;
- la figure 2 illustre un discriminateur tronqué selon la présente invention ;
- la figure 3 montre la caractéristique de transfert du discriminateur de l'invention.

### Exposé détaillé d'un mode de réalisation

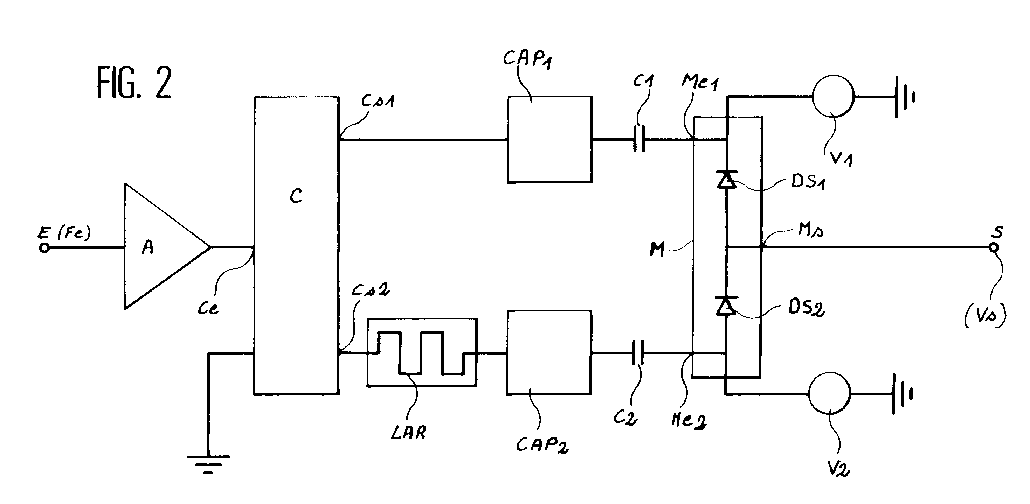

Le discriminateur de fréquence représenté sur la figure 2 comprend des moyens déjà représentés sur la figure 1, à savoir : une entrée générale E, un coupleur C à une entrée Ce et à une première et seconde sortie Cs1, Cs2, une première voie reliée à la première sortie Cs1 et une seconde voie reliée à la seconde sortie Cs2, un circuit de retard CAR disposé dans la seconde voie, un mélangeur M à une première et une seconde entrées Me1, Me2, la première entrée Me1 étant reliée à la première voie et la seconde entrée Me2 étant reliée à la seconde voie. Ce mélangeur est constitué par une première diode SCHOTTKY DS1 reliée à la première voie et par une seconde diode SCHOTTKY DS2 reliée à la seconde voie, ces deux diodes étant montées en série et présentant un point milieu Ms relié à la sortie générale S du discriminateur.

Le discriminateur de la figure 2 est caractérisé par le fait qu'il comprend en outre :
- un amplificateur de puissance A disposé entre l'entrée générale E et le coupleur C,
- dans la première voie, un premier circuit d'ajustement de phase CAP1 suivi d'un premier condensateur de liaison C1,
- dans la seconde voie, un second circuit d'ajustement de phase CAP2 suivi d'un second condensateur de liaison C2,
- un premier circuit de polarisation de la première diode SCHOTTKY comprenant une première source de tension réglable V1 apte à polariser faiblement en direct la première diode DS1,
- un second circuit de polarisation de la seconde diode SCHOTTKY comprenant une seconde source de tension réglable V2 apte à polariser faiblement en direct la seconde diode DS2.

Pour obtenir la caractéristique de transfert tronquée, il faut que l'amplificateur de puissance A puisse délivrer un signal non modulé d'au moins +7 dBm. Le retard apporté par le circuit CAR est déterminé en fonction du débit du signal numérique modulant en fréquence le laser émetteur. Les deux circuits d'ajustement de phase CAP1 et CAP2 permettent de caler les fréquences f1 et f2 sur les plages horizontales de la caractéristique de transfert.

Les deux circuits de polarisation sont constitués par des sources de tension réglables présentant une impédance de source L, R et sont reliés l'un à l'anode d'une des diodes SCHOTTKY et l'autre à la cathode de l'autre diode. Les tensions fournies polarisent les diodes en direct avec des potentiels très faibles, de quelques dizaines de millivolts aux bornes de chacune d'elles. Les ajustements de potentiels sont tels que l'on obtienne la troncature de la caractéristique de transfert avec des amplitudes maximale et minimale plates de part et d'autre du niveau 0 volt.

Le gain de l'amplificateur A peut être réglé automatiquement à la valeur appropriée par un circuit de contrôle automatique de gain non représenté qui reboucle la sortie de l'amplificateur à une entrée de réglage du gain de cet amplificateur.

La caractéristique de transfert typique obtenue est illustrée sur la figure 3. La fréquence du signal d'entrée Fe est portée en abscisses et la tension de sortie Vs en ordonnées. La valeur fo désigne la fréquence d'accord, f1 la fréquence inférieure, f2 la fréquence supérieure ; Δf1 désigne la variation de fréquence autour de la fréquence inférieure et Δf2 la variation de la fréquence autour de la fréquence supérieure; Δvo est la variation de tension correspondant à une variation de fréquence Δfo autour de la fréquence d'accord, Δv1 et Δv2 sont les variations de tension aux extrémités de la caractéristique.

## Revendications

1. Discriminateur de fréquence comprenant une entrée générale (E), un coupleur (C) à une entrée (Ce) et à une première et une seconde sorties (Cs1, Cs2), une première voie reliée à la première sortie (Cs1) et une seconde voie reliée à la seconde sortie (Cs2), un circuit de retard (CAR) disposé dans la seconde voie, un mélangeur (M) à une première et une seconde entrées (Me1, Me2), la première entrée (Me1) étant reliée à la première voie et la seconde entrée (Me2) étant reliée à la seconde voie, ce mélangeur étant constitué par une première diode SCHOTTKY (DS1) reliée à la première voie et par une seconde diode SCHOTTKY (DS2) reliée à la seconde voie, ces deux diodes étant montées en série et présentant un point milieu (Ms) relié à une sortie générale (S) du discriminateur, ce discriminateur étant caractérisé par le fait qu'il comprend en outre :
- un amplificateur de puissance (A) disposé entre l'entrée générale (E) et le coupleur (C),
- dans la première voie, un premier circuit d'ajustement de phase (CAP1),
- dans la seconde voie, un second circuit d'ajustement de phase (CAP2),
- un premier circuit de polarisation de la première diode SCHOTTKY comprenant une première source de tension réglable (V1) apte à polariser faiblement en direct la première diode (DS1),
- un second circuit de polarisation de la seconde diode SCHOTTKY comprenant une seconde source de tension réglable (V2) apte à polariser faiblement en direct la seconde diode (DS2),
l'amplificateur A, les premier et second circuits d'ajustement de phase (CAP1, CAP2) et les premier et second circuits de polarisation (V1, V2) étant ajustés pour que le discriminateur présente une caractéristique de transfert avec deux extrémités larges et plates.
